# EUROPÄISCHE PATENTSCHRIFT

(11) **EP 0 956 175 B1**
(45) Veröffentlichungstag und Bekanntmachung des Hinweises auf die Patenterteilung: **07.08.2002**
(21) Anmeldenummer: 98964565.0
(22) Anmeldetag: 02.11.1998
(51) Int. Cl.: B23B 31/20

(54) **BOHR- BZW. FRÄSKOPF**
DRILL OR MILLING HEAD
TETE D'ALESAGE OU DE FRAISAGE

(30) Priorität: 05.11.1997 DE 19748735
(43) Veröffentlichungstag der Anmeldung: 17.11.1999
(73) Patentinhaber: PMV D.O.O., 4290 Trzic (SI)
(72) Erfinder: PODLIPEC, Milan, 1360 Vrhnika (SI); PODLIPEC, Bostjan, 13609 Vrhnika (SI); ZEPIC, Janez, 1113 Ljubljana (SI)
(74) Vertreter: Braun, Dieter, Dipl.-Ing.
(86) Internationale Anmeldenummer: IB9802142
(87) Internationale Veröffentlichungsnummer: WO9922897

(56) Entgegenhaltungen:
- WO-A-87/01318
- DE-A- 3 434 699
- GB-A- 106 231
- US-A- 2 737 072
- US-A- 2 805 074
- US-A- 3 724 563

## Beschreibung

Diese Erfindung betrifft einen Bohr- bzw. Fraskopf nach dem Oberbegriff des Anspruchs 1 Insbesondere ist dieser Bohr- bzw. Fräskopf für Maschinen geeignet, die zur Herstellung von Feinstrukturen dienen, wie Leiterplattenfrasmaschinen und Graviermaschinen.

Bekannt ist, bei den gattungsgemäßen Bohr- oder Fräskopfen zum Wechseln des Werkzeugs eine Spannzangen-Betätigungsstange vorzusehen, die durch eine hohle Antriebswelle des Motors bzw. des Bohr- oder Fraskopfes hindurchgeführt ist und über eine Verzahnung mit der Spannzange in Eingriff steht. Zum Öffnen der Spannzange wird die Betätigungsstange entweder manuell über einen oberhalb des Motors befindlichen handbetätigten Knauf oder pneumatisch, in Richtung der Spannzange geschoben, wodurch die Spannzange gedreht. d. h. verschraubt, und somit geoffnet wird. Der Motor muß dazu jedoch vorher ausgeschaltet werden. Wenn dies vergessen wird, kommt es zu einer Beschädigung des Bohr- bzw. Fräskopfes, da dann die nicht rotierende Betätigungsstange und die rotierende Spannzange zusammengeführt werden. Es kann dann sogar passieren, daß die Spannzange sich vollständig vom Bohr- bzw. Fräskopf löst und damit eine Verletzungsgefahr für Personen entsteht.

Aus der DE 34 34 699 C2 ist ein Bohr- bzw. Fraskopf nach dem Oberbegriff des Anspruchs 1 bekannt. Nachteilig ist jedoch auch bei diesem Bohr- bzw. Fräskopf. daß beim Wechseln eines eingespannten Werkzeuges zumindest die Gefahr einer Beschadigung des Bohr- bzw. Fräskopfes besteht, wenn vorher versehentlich der Antriebsmotor nicht abgeschaltet wurde.

Der Erfindung liegt daher die Aufgabe zugrunde einen gattungsgemaßen Bohr- bzw. Fraskopf zur Verfügung zu stellen. bei dem beim Wechseln des Werkzeugs keine Beschädigung des Bohr- bzw. Fraskopfes und keine Verletzungsgefahr auftreten kann, wenn übersehen wurde, vorher den Motor abzuschalten, und somit die Bedienung zu vereinfachen und sicherer zu gestalten

Diese Aufgabe wird durch die Merkmale des Anspruchs 1 gelost. Die weitere Ausgestaltung der Erfindung ist den Unteransprüchen zu entnehmen.

Dadurch, daß die für das axiale Verschieben der Spannzange erforderliche Kraft über eine Reibkupplung übertragen wird, ist ausgeschlossen, daß eine versehentlich noch rotierende Spannzange beim Offnen mit einem nicht rotierenden Teil in formschlussigen Eingriff gelangt. Die axiale Schubkraft wird vielmehr über die Reibkupplung kraftschtussig auf die Spannzange bzw. die Welle ubertragen, mit der die Spannzange fest verbunden ist.

Vorzugweise besteht die Reibkupplung aus einem axial und relativ zur Welle bewegbaren Teil und einem axial verschiebbaren, fest mit der Welle verbundenen Teil, wobei die beiden Teile zueinander konforme Flächen aufweisen, die beim Betätigen des Schnellwechselmechanismus in Kontakt gelangen. Dabei ist vorgesehen, daß die beiden Teile werkzeugseitig gegen die Kraft jeweils einer Feder abgestützt sind. Auf diese Weise ist gewährleistet, daß die beiden Teile im Ruhezustand einen Abstand voneinander aufweisen und beim Zusammenführen, in dem Fall, daß sich das fest mit der Welle verbundene Teil dreht, nur eine Reibung zwischen den Flächen auftritt, die nicht zu einer Beschädigung des Bohr- bzw. Fräskopfes führt.

Gemäß einer bevorzugten Ausgestaltung der Erfindung ist das relativ zur Welle bewegbare Teil zylinderförmig und konzentrisch zur Welle angeordnet und weist am motorseitigen Ende eine ringförmige Schulter auf. Das fest mit der Welle verbundene Teil ist eine Manschette mit einem umlaufenden Ansatz. Die konformen Flächen sind an der ringförmigen Schulter und dem umlaufenden Ansatz plan und vertikal zur Welle ausgebildet.

Der Schnellwechselmechanismus kann manuell über eine Handhabe betätigbar sein. Dabei kann auch vorgesehen sein, daß die Handhabe in der Stellung, in der die Spannzange geöffnet ist, arretierbar ist. Dies hat den Vorteil, daß der Operateur beide Hände frei hat, zum Handhaben des Bohr- bzw. Fräswerkzeuges. Beim Stand der Technik muß hingegen bei manueller Betätigung des Schnellwechselmechanismus der Betätigungsknauf während des gesamten Auswechselvorganges gedrückt bleiben.

Die Handhabe kann zum Beispiel ein Hebel sein, der einen Griffabschnitt und einen innerhalb eines Gehäuses des Bohr- bzw. Fräskopfes angeordneten Funktionsabschnitt aufweist. Dabei ist vorgesehen, daß dieser Funktionsabschnitt des Hebels in Ruhestellung einen spitzen Winkel zu einer Horizontalebene und in Betätigungsstellung einen rechten Winkel mit der Welle einnimmt und außerdem motorseitig gegen eine unbewegliche Fläche des Bohr- bzw. Fräskopfes und werkzeugseitig gegen das relativ zur Welle bewegbare Teil anliegt. Der Funktionsabschnitt des Hebels weist in der Betätigungsstellung in Axialrichtung eine größere maximale Ausdehnung auf, als in der Ruhestellung. Dadurch wird erreicht, daß durch das Bewegen des Hebels aus seiner Ruhestellung in seine Betätigungsstellung das relativ zur Welle bewegbare Teil der Reibkupplung zum werkzeugseitigen Ende des Bohr- bzw. Fräskopfes hin verschoben wird und dabei, wie unten näher beschrieben wird, die Welle bzw. die Spannzange mitverschoben wird, um so das Öffnen der Spannzange zu bewirken.

Der Funktionsabschnitt des Hebels ist vorzugsweise ringförmig und konzentrisch zur Welle angeordnet. Wenn der Außendurchmesser des Funktionsabschnittes gleich dem Innendurchmesser des Gehäuses ist und die Außenseite des Funktionsabschnittes konvex gewölbt ist, kann erreicht werden, daß dieser in jeder Lage entlang seines gesamten Umfangs gegen das Gehäuse des Bohr- bzw. Fräskopfes anliegt, abgesehen von einem Bereich, in dem der Griffabschnitt ansetzt. Auf diese Weise ist erreicht, daß der Hebel nur in seiner Winkelstellung zur Welle verändert und gegebenenfalls zur Arretierung genngfugig um die Axialrichtung des Bohr- und Fräskopfes gedreht werden kann, darüber hinaus aber festliegt. Der Griffabschnitt ragt durch eine Öffnung des Gehäuses.

Die in Abhängigkeit von seiner Stellung veränderbare maximale Ausdehnung des Funktionsabschnittes in Axialrichtung wird vorzugsweise dadurch erreicht, daß auf dem Funktions-abschnitt des Hebels, werkzeugseitig in der zur Längsachse des Hebels senkrechten Ebene, in der in Betätigungsstellung des Hebels die Welle liegt, beidseitig der Welle jeweils ein Nocken und motorseitig ein weiterer Nocken, gegenüberliegend von dem Griffteil des Hebels angeordnet ist. Die beiden werkzeugseitigen Nocken und der motorseitige Nocken sind somit um 90° versetzt angeordnet. Daher weist der Funktionsabschnitt in horizontaler Lage, also in Betätigungsstellung, eine größere axiale Ausdehnung auf, als in der geneigten Lage der Ruhestellung.

Die beiden werkzeugseitigen Nocken drücken beim Bewegen des Hebels aus seiner Ruhestellung in seine Betätigungsstellung gegen eine Anschlagfläche des in Axialrichtung relativ zur Welle bewegbaren Teiles. Dieses bewegt sich dann gegen die fest mit der Welle verbundene Manschette. Durch Betätigung des Hebels wird somit die Welle zum werkzeugseitigen Ende des Bohr- und Fräskopfes hin verschoben. Mit der Welle wird auch die Spannzange relativ zu der Spannhülse verschoben. Dadurch öffnet sich die Spannzange, deren Greifarme im Endabschnitt der Spannhülse gegen eine sich in Axialrichtung zum Motor hin konisch verjüngende Innenfläche der Spannhülse anliegen.

Der Schnellwechselmechanismus kann auch pneumatisch betätigbar sein.

Es kann vorgesehen sein, daß, um eine einfache Trennung von Motor und Bohr- bzw. Fräskopf zu ermöglichen, eine Antriebswelle des Motors und die Welle des Bohr- bzw. Fräskopfes über eine Kupplung miteinander verbunden sind. Vorzugsweise handelt es sich bei dieser Kupplung um eine elastische Kupplung, damit Schwingungen in Axialrichtung aufgefangen werden.

Bei Bedarf kann der Bohr- bzw. Fräskopf über die Kupplungsscheibe sehr einfach mit unterschiedlichen Motoren verbunden werden. Es ergibt sich eine modulare Bauweise eines Bohr- bzw. Fräskopfes, der eine völlig selbständige Einheit mit dem Mechanismus für einen schnellen und sicheren Werkzeugwechsel darstellt.

In der Zeichnung ist ein Ausführungsbeispiel der Erfindung dargestellt und wird im folgenden näher beschrieben. Es zeigen:
Figur 1, eine Schnittansicht des Bohr- bzw. Fräskopfes;
Figur 2, eine Schnittansicht des Gehäuses des Bohr- bzw. Fräskopfes, das eine Arretiervorrichtung einer Handhabe für den Schnellwechselmechanismus aufweist.

Ein Bohr- bzw. Fräskopf 1 weist ein Gehäuse 2 mit einem Flanschteil 3 auf, über das ein Motor 3a angeschlossen werden kann. Auf einer Antriebswelle 4 des Motors 3a ist ein Aufsatz 5 befestigt, der eine elastische Kupplungsscheibe 6 enthält. Der Kupplungsscheibe 6 liegt ein auf einer Antriebswelle 7 des Bohr- bzw. Fräskopfes 1 befestigter tellerartiger Aufsatz 8 gegenüber, der zusammen mit dem Aufsatz 5 der Motorantriebswelle 4 und zwei Verbindungsstiften 9 und 10 eine Kupplung zwischen den Antriebswellen 4 und 7 des Motors 3a und des Bohr- bzw. Fräskopfes 1 bildet. Die Verbindungsstifte 9 und 10 sind in dem Aufsatz 8 der Welle 7 des Bohr- bzw. Fräskopfes 1 befestigt und greifen in Vertiefungen 11 und 12 der Kupplungsscheibe 6 ein.

Ferner weist der Bohr- bzw. Fräskopf 1 einen Hebel 13 mit einem innerhalb des Gehäuses 2 angeordneten Funktionsabschnitt 14 und einem aus dem Gehäuse 2 herausragenden Griffabschnitt 15 auf. Der Funktionsabschnitt 14 ist ringförmig und konzentrisch zur Welle 7 des Bohr- und Fräskopfes 1. Ferner weist der Funktionsabschnitt 14 einen solchen Durchmesser auf und ist an der Außenseite derart konvex gewölbt, daß er in jeder Lage bis auf einen Bereich, in dem der Griffabschnitt 15 ansetzt, entlang des gesamten Umfangs gegen das Gehäuse 2 des Bohr- bzw. Fräskopfes 1 anliegt. Auf der dem Motor 3a zugewandten Seite des Funktionsabschnittes 14 ist ein Nocken 16 angeordnet. Auf der gegenüberliegenden Seite des Funktionsabschnittes 14 sind zwei weitere Nocken 17 angeordnet, von denen nur einer gezeigt ist. Diese beiden Nocken 17 liegen in der um 90° zur Schnittebene um die Welle 7 gedrehten Ebene. Motorseitig liegt der Funktionsabschnitt 14 gegen einen festliegenden Ring 18 an, werkzeugseitig gegen ein zylinderförmiges, in Axialrichtung bewegbares Teil 19, das werkzeugseitig durch eine Feder 20 gegen einen Vorsprung 21 des Gehäuses 2 abgestützt ist. An dem dem Motor 3a zugewandten Ende weist das Teil 19 eine ringförmige Schulter 22 auf, die einen rechten Winkel mit der Wandung des Teils 19 einnimmt.

Eine Manschette 23 mit einem umlaufenden Ansatz 24 ist fest mit der Welle 7 verbunden. Der Ansatz 24 ist parallel zu der Schulter 22 ausgerichtet und so dimensioniert, daß die sich gegenüberliegenden planen Flächen der Schulter 22 und des Ansatzes 24 bei einer Verschiebung des Teiles 19 zum werkzeugseitigen Ende des Bohr- und Fräskopfes in Kontakt gelangen. Die Manschette 23 ist werkzeugseitig durch eine Feder 25 gegen eine Spannhülse 26 abgestützt. Die Spannhülse 26 umschließt einen Abschnitt der Welle 7 und, bis auf einen kleinen Endbereich, eine gesamte Spannzange 27, in die die Welle 7 übergeht. Ein quer durch die Welle 7 hindurch verlaufender Stift 28 ragt beidseitig der Welle 7 in jeweils ein parallel zur Welle 7 verlaufendes Langloch 29 bzw. 30 der Spannhülse 26.

Die Spannhülse 26 ist mittels zweier Drehlager 31 und 32 gelagert und gegen ein axiales Verschieben durch einen Spannring 33 gesichert. Die Spannhülse 26 weist in ihrem Endabschnitt eine sich in Axialrichtung zum Motor 3a hin konisch verjüngende Innenfläche 34 auf. Gegen diese Innenfläche 34 liegen Greifarme 35 der Spannzange 27 an, wenn diese geschlossen ist.

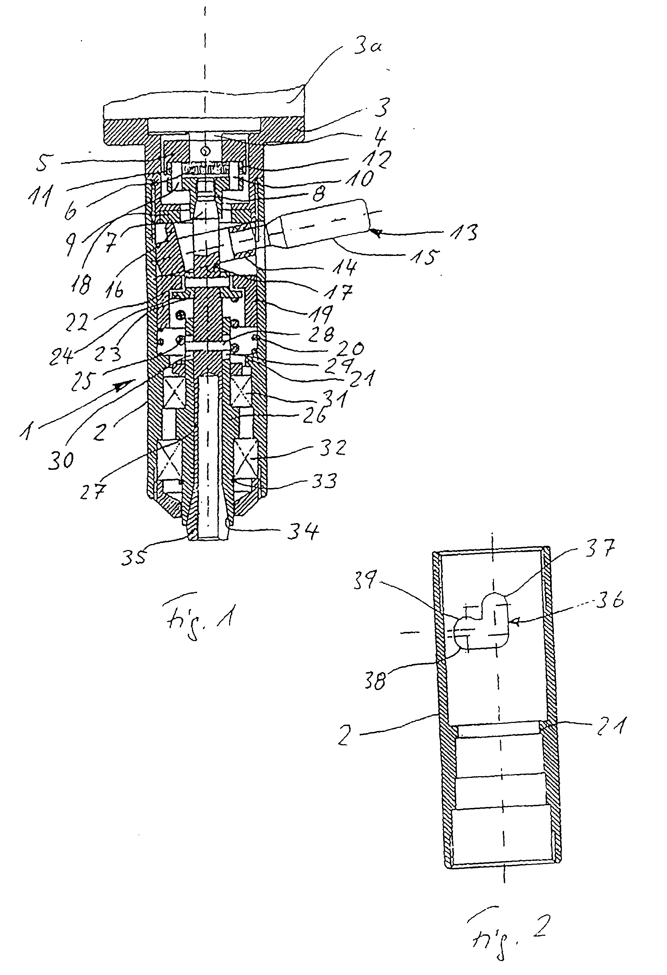

Wie in Figur 2 gezeigt ist, ist bei dieser Ausführungsform der Erfindung eine Arretierung des Hebels 13 in seiner Betätigungsstellung, also im geöffneten Zustand der Spannzange 27, vorgesehen. Dazu ist eine im wesentlichen rechtwinkelig geformte Öffnung 36 für den Hebel 13 in dem Gehäuse 2 vorgesehen, wobei ein Schenkel 37 in Axialrichtung ausgerichtet ist. Durch den zweiten Schenkel 38, der an seinem äußeren Ende eine in der Richtung des Schenkels 37 liegende Ausbuchtung 39 aufweist, ist eine Raste für den Hebel 13 gegeben.

Wenn in den erfindungsgemäßen Bohr- bzw. Fräskopf 1 ein Werkzeug (nicht gezeigt) eingespannt ist. befindet sich der Hebel 13 in seiner in Figur 1 gezeigten Ruhestellung. In dieser Stellung, in der der Funktionsabschnitt 14 des Hebels 13 seine geringste axiale Ausdehnung aufweist, wird er durch die durch das zylinderförmige Teil 19 übertragene Kraft der Feder 20 gehalten. Wird der Hebel 13 in seine horizontale Lage bewegt, so vergrößert sich die axiale Ausdehnung des Funktionsabschnitts 14, wodurch das bewegbare Teil 19 zum werkzeugseitigen Ende des Bohr- bzw. Fräskopfes hin verschoben wird. Dabei gelangen die beiden sich gegenüberliegenden planen Flächen der Schulter 22 und des Ansatzes 24 in Kontakt, so daß auch die Manschette 23 verschoben wird. Da diese fest mit der Welle 7 verbunden ist, bewegen sich auch die Welle 7 und die Spannzange 27, die unmittelbar an die Welle 7 anschließt, zum werkzeugseitigen Ende des Bohr- bzw. Fräskopfes 1 hin. Infolge der sich daraus ergebenden Verschiebung der Spannzange 27, gegenüber der in Axialrichtung festliegenden Spannhülse 26, wird der kraftschlüssige Eingriff der konischen Innenfläche 34, der Spannhülse 26 und der Greifarme 35 der Spannzange 27 aufgehoben, wodurch das von den Greifarmen 35 gehaltene Werkzeug freigegeben wird.

Der Stift 28 und die Langlöcher 29 und 30 stellen eine Mitnehmervorrichtung dar, durch die erreicht wird, daß sich die Spannhülse 26 stets mit der Welle 7 mitdreht, also keine Reibung zwischen diesen beiden Teilen auftritt. Durch die Langlöcher 29 und 30 ist sichergestellt, daß sich dabei die Welle 7 gegenüber der Spannhülse 26 axial verschieben kann.

Beim Bewegen des Hebels 13 in seine Betätigungsstellung bewegen sich auch die Verbindungsstifte 9 und 10 der Antriebswellenkupplung in die Richtung des werkzeugseitigen Endes des Bohr- bzw. des Fräskopfes 1. Jedoch gelangen diese dabei nicht vollständig aus den Vertiefungen 11 und 12, so daß nicht ausgekuppelt wird.

Zum Arretieren wird der Hebel 13 in seiner Betätigungsstellung geringfügig um die Axialrichtung des Bohr- und Fräskopfes 1 gedreht, so daß er von der Ausbuchtung 39 aufgenommen und gehalten wird.

Wenn der Motor 3a vor dem Betätigen des Hebels 13 versehentlich nicht abgeschaltet wurde, kann dennoch keine Beschädigung des Bohr- bzw. Fräskopfes 1 auftreten bzw. keine Verletzungsgefahr für Personen entstehen, da die Kontaktflächen des zylinderförmigen Teiles 19 und der Manschette 23 für die dann entstehende Reibungswärme ausgelegt sind und sich die Spannzange 27 nicht von der Welle 7 lösen kann.

## Patentansprüche

1. Bohr- bzw. Fräskopf (1), insbesondere für Leiterplattenfräsmaschinen und Graviermaschinen, mit einer über einen Schnellwechselmechanismus betätigbaren Spannzange (27) und einer mit einem Motor (3a) verbundenen Antriebswelle (7), wobei die Spannzange (27) durch axiales Verschieben gegenüber einer Spannhülse (26) geöffnet wird, **dadurch gekennzeichnet, daß** die dazu erforderliche Kraft über eine Reibkupplung (19, 23) übertragen wird.

2. Bohr- bzw. Fräskopf (1) nach Anspruch 1, **dadurch gekennzeichnet, daß** die Reibkupplung aus einem axial und relativ zur Welle (7) bewegbaren Teil (19) und einem axial verschiebbaren, fest mit der Welle (7) verbundenen Teil (23) besteht, wobei die beiden Teile zueinander konforme, in Kontakt gelangende Flächen aufweisen und werkzeugseitig gegen die Kraft jeweils einer Feder (20. 25) abgestützt sind.

3. Bohr- bzw. Fräskopf (1) nach Anspruch 2, **dadurch gekennzeichnet, daß** das relativ zur Welle (7) bewegbare Teil (19) zylinderförmig und konzentrisch zur Welle (7) angeordnet ist und am motorseitigen Ende eine ringförmige Schulter (22) aufweist, sowie, daß das fest mit der Welle (7) verbundene Teil von einer Manschette (23) mit einem umlaufenden Ansatz (24) gebildet ist und die konformen Flächen plan und vertikal zur Welle (7) ausgebildet sind.

4. Bohr- bzw. Fräskopf (1) nach einem oder mehreren der vorhergehenden Ansprüche, **dadurch gekennzeichnet, daß** der Schnellwechselmechanismus eine Handhabe zur Betätigung aufweist.

5. Bohr- bzw. Fräskopf (1) nach Anspruch 4, **dadurch gekennzeichnet, daß** die Handhabe in der Stellung, in der die Spannzange (27) geöffnet ist, in einer Raste arretierbar ist.

6. Bohr- bzw. Fräskopf (1) nach Anspruch 4 oder 5, **dadurch gekennzeichnet, daß** die Handhabe ein Hebel (13) ist.

7. Bohr- bzw. Fräskopf (1) nach den Ansprüchen 2 oder 3 und 6, **dadurch gekennzeichnet, daß** der Hebel einen Griffabschnitt (15) und einen innerhalb eines Gehäuses (2) des Bohr- bzw. Fräskopfes (1) angeordneten Funktionsabschnitt (14) aufweist, der in Ruhestellung einen spitzen Winkel zu einer Horizontalebene, und in Betätigungsstellung einen rechten Winkel mit der Welle (7) einnimmt und ferner motorseitig gegen eine unbewegliche Fläche des Bohr- bzw. Fräskopfes (1) und werkzeugseitig gegen das relativ zur Welle (7) bewegbare Teil (19) anliegt, wobei der Funktionsabschnitt (14) des Hebels (13) in der Betätigungsstellung in Axialrichtung eine größere maximale Ausdehnung, als in der Ruhestellung aufweist.

8. Bohr- bzw. Fräskopf (1) nach Anspruch 7, **dadurch gekennzeichnet, daß** der Funktionsabschnitt des Hebels (13) ringförmig und konzentrisch zur Welle (7) ist.

9. Bohr- bzw. Fräskopf (1) nach Anspruch 8, **dadurch gekennzeichnet, daß** der Funktionsabschnitt (14) einen solchen Durchmesser aufweist und an der Außenseite derart konvex gewölbt ist, daß er in jeder Lage bis auf einen Bereich, in dem der Griffabschnitt (15) ansetzt, entlang des gesamten Umfangs gegen das Gehause (2) des Bohr- bzw. Fräskopfes (1) anliegt.

10. Bohr- bzw. Fräskopf (1) nach einem oder mehreren der Ansprüche 7 bis 9, **dadurch gekennzeichnet, daß** auf dem Funktionsabschnitt (14) des Hebels (13), werkzeugseitig in der zur Längsachse des Hebels (13) senkrechten Ebene, in der in Betätigungsstellung des Hebels (13) die Welle (7) liegt, beidseitig der Welle (7) jeweils ein Nocken (17) und motorseitig ein weiterer Nocken (16), gegenüberliegend von dem Griffabschnitt (15) des Hebels (13) angeordnet ist.

11. Bohr- bzw. Fräskopf (1) nach einem oder mehreren der Ansprüche 1 bis 3, **dadurch gekennzeichnet, daß** der Schnellwechselmechanismus pneumatisch betätigbar ist.

12. Bohr- bzw. Fräskopf (1) nach einem oder mehreren der vorhergehenden Ansprüche, **dadurch gekennzeichnet, daß** die Welle (7) des Bohr- bzw. Fräskopfes (1) über eine elastische Kupplungsscheibe (6) mit einer Antriebswelle (4) des Motors (3a) verbunden werden kann, derart, daß der Bohr- bzw. Fräskopf (1) eine selbständige Einheit mit dem Mechanismus für einen schnellen und sicheren Werkzeugwechsel bildet.

13. Bohr- bzw. Fräskopf (1) nach einem oder mehreren der vorhergehenden Ansprüche, **dadurch gekennzeichnet, daß** der Bohr- bzw. Fräskopf (1) über die Kupplungsscheibe (6), je nach Bedarf, mit unterschiedlichen Motoren (3a) verbunden werden kann.

## Claims

1. Drilling or milling head (1), in particular for printed circuit board milling machines and engraving machines, with a collet chuck (27) actuatable via a quick change mechanism and a drive shaft (7) connected to a motor (3a), the collet chuck (27) being opened by axial displacement relative to the split taper sleeve (26), **characterised in that** the force required for this purpose is transmitted via a friction clutch (19, 23).

2. Drilling or milling head (1) according to claim 1, **characterised in that** the friction clutch consists of a part (19) movable axially and relative to the shaft (7) and an axially displaceable part (23) rigidly connected to the shaft (7), the two parts having mutually conformal faces which come into contact and are supported at the tool-side against the force of a respective spring (20, 25).

3. Drilling or milling head (1) according to claim 2, **characterised in that** the part (19) movable relative to the shaft (7) is cylindrical and arranged concentrically with the shaft (7) and at the motor-side end has an annular attachment (22), **in that** the part rigidly connected to the shaft (7) is formed by a collar (23) with a peripheral attachment (24) and the conformal faces are designed flat and vertical to the shaft (7).

4. Drilling or milling head (1) according to any one or more of the preceding claims, **characterised in that** the quick change mechanism has a handle for actuation.

5. Drilling or milling head (1) according to claim 4, **characterised in that** the handle may be locked in a catch in the position in which the collet chuck (27) is open.

6. Drilling or milling head (1) according to claim 4 or 5, **characterised in that** the handle is a lever (13).

7. Drilling or milling head (1) according to claims 2 or 3 and 6, **characterised in that** the lever has a grip portion (15) and a functional portion (14) arranged inside a housing (2) of the drilling or milling head (1), the functional portion (14) assuming an acute angle to the horizontal plane in the rest position and a right angle to the shaft (7) in the actuating position and, moreover, resting against a stationary face of the drilling or milling head (1) at the motor-side and against the part (19) movable relative to the shaft (7) at the tool-side, the functional portion (14) of the lever (13) having a larger maximum extension in the axial direction in the actuating position than in the rest position.

8. Drilling or milling head (1) according to claim 7, **characterised in that** the functional portion of the lever (13) is annular and concentric with the shaft (7).

9. Drilling or milling head (1) according to claim 8, **characterised in that** the functional portion (14) has a diameter and is convexly curved at the outer side in such a way that it rests against the housing (2) of the drilling or milling head (1) along the entire periphery in each position except for a region in which the grip portion (15) adjoins.

10. Drilling or milling head (1) according to any one or more of claims 7 to 9, **characterised in that**, on the functional portion (14) of the lever (13) at the tool-side in the plane which is perpendicular to the longitudinal axis of the lever (13) and in which the shaft (7) is located in the actuating position of the lever (13), on either side of the shaft (7) a respective cam (17) and at the motor-side a further cam (16) is arranged remote from the grip portion (15) of the lever (13).

11. Drilling or milling head (1) according to any one or more of claims 1 to 3, **characterised in that** the quick change mechanism can be actuated pneumatically.

12. Drilling or milling head (1) according to any one or more of the preceding claims, **characterised in that** the shaft (7) of the drilling or milling head (1) can be connected via a resilient clutch disc (6) to a drive shaft (4) of the motor (3a) in such a way that the drilling or milling head (1) forms an independent unit with the mechanism for a quick and reliable tool change.

13. Drilling or milling head (1) according to any one or more of the preceding claims, **characterised in that** the drilling or milling head (1) can be connected via the clutch disc (6) to different motors (3a), as required.

## Revendications

1. Tête d'alésage ou de fraisage (1), en particulier pour des machines de fraisage de cartes imprimées et des fraiseuses à graver, comportant une pince de serrage (27) pouvant être actionnée au moyen d'un mécanisme de changement rapide et un arbre d'entraînement (7) relié à un moteur (3a), la pince de serrage (27) étant ouverte par le déplacement axial par rapport à une douille de serrage (26), **caractérisée en ce que** la force nécessaire à cet effet est transmise par un accouplement à friction (19, 23).

2. Tête d'alésage ou de fraisage (1) selon la revendication 1, **caractérisée en ce que** l'accouplement à friction comprend une partie (19) mobile dans le sens axial et par rapport à l'arbre (7) et une partie (23) coulissable dans le sens axial et reliée de façon fixe à l'arbre (7), les deux parties présentant des surfaces réciproquement conformes et arrivant en contact et étant soutenues côté outil contre la force respectivement d'un ressort (20, 25).

3. Tête d'alésage ou de fraisage (1) selon la revendication 2, **caractérisée en ce que** la partie (19) mobile par rapport à l'arbre (7) est en forme de cylindre et est disposée de façon concentrique par rapport à l'arbre (7) et présente un épaulement (22) de forme annulaire sur l'extrémité côté moteur, et **en ce que** la partie, reliée de façon fixe à l'arbre (7), d'une manchette (23) est formée avec une embase (24) périphérique et les surfaces conformes sont conçues de façon plane et verticale par rapport à l'arbre (7).

4. Tête d'alésage ou de fraisage selon l'une quelconque ou plusieurs des revendications précédentes, **caractérisée en ce que** le mécanisme de changement rapide présente une manette pour l'actionnement.

5. Tête d'alésage ou de fraisage (1) selon la revendication 4, **caractérisée en ce que** la manette peut être bloquée dans un cran dans la position dans laquelle la pince de serrage (27) est ouverte.

6. Tête d'alésage ou de fraisage (1) selon la revendication 4 ou 5, **caractérisée en ce que** la manette est un levier (13).

7. Tête d'alésage ou de fraisage (1) selon les revendications 2 ou 3 et 6, **caractérisée** en que le levier présente une partie de prise (15) et une partie fonctionnelle (14) disposée à l'intérieur d'un boîtier (2) de la tête d'alésage ou de fraisage (1), qui forme un angle aigu avec un plan horizontal dans la position de repos et un angle droit avec l'arbre (7) dans la position active et s'appuie également côté moteur contre une surface immobile de la tête d'alésage ou de fraisage (1) et côté outil contre la partie (19) mobile par rapport à l'arbre (7), la partie fonctionnelle (14) du levier (13) présentant dans la position active en direction axiale une extension maximale plus grande que dans la position de repos.

8. Tête d'alésage ou de fraisage (1) selon la revendication 7, **caractérisée en ce que** la partie fonctionnelle du levier (13) est de forme annulaire et concentrique par rapport à l'arbre (7).

9. Tête d'alésage ou de fraisage (1) selon la revendication 8, **caractérisée en ce que** la partie fonctionnelle (14) présente un tel diamètre et est courbée de façon convexe sur le côté extérieur de telle sorte qu'elle s'appuie dans tous les emplacements à l'exception d'une zone, où la partie de prise (15) est fixée, le long de l'ensemble de la périphérie contre le boîtier (2) de la tête d'alésage ou de fraisage (1).

10. Tête d'alésage ou de fraisage (1) selon l'une quelconque ou plusieurs des revendications 7 à 9, **caractérisée en ce que** sur la partie fonctionnelle (14) du levier (13), une came (17) est disposée sur chacun des deux côtés de l'arbre (7) côté outil dans le plan perpendiculaire à l'axe longitudinal du levier (13), dans lequel se situe l'arbre (7) dans la position de commande du levier (13), et une autre came (16) est disposée côté moteur en face de la partie de prise (15) du levier (13).

11. Tête d'alésage ou de fraisage (1) selon l'une quelconque ou plusieurs des revendications 1 à 3, **caractérisée en ce que** le mécanisme de changement rapide peut être actionné de façon pneumatique.

12. Tête d'alésage ou de fraisage (1) selon l'une quelconque ou plusieurs des revendications précédentes, **caractérisée en ce que** l'arbre (7) de la tête d'alésage ou de fraisage (1) peut être relié à un arbre d'entraînement (4) du moteur (3a) au moyen d'un disque d'accouplement (6) élastique de telle sorte que la tête d'alésage ou de fraisage (1) forme une unité autonome avec le mécanisme destiné à un changement d'outil rapide et sûr.

13. Tête d'alésage ou de fraisage (1) selon l'une quelconque ou plusieurs des revendications précédentes, **caractérisée en ce que** la tête d'alésage ou de fraisage (1) peut être reliée au moyen du disque d'accouplement (6), selon les besoins, avec différents moteurs (3a).
